(19) 

**Europäisches Patentamt**
**European Patent Office**
**Office européen des brevets**

(11) **EP 1 018 027 B1**

(12) **EUROPEAN PATENT SPECIFICATION**

(45) Date of publication and mention
of the grant of the patent:
**07.05.2008 Bulletin 2008/19**

(51) Int Cl.:
***G01R 31/08*** *(2006.01)* ***H02H 7/26*** *(2006.01)*

(21) Application number: **98941445.3**

(22) Date of filing: **26.08.1998**

(86) International application number:
**PCT/FI1998/000668**

(87) International publication number:
**WO 1999/010753 (04.03.1999 Gazette 1999/09)**

(54) **METHOD FOR THE LOCATION OF A HIGH-RESISTANCE EARTH FAULT IN A POWER DISTRIBUTION SYSTEM ON THE BASIS OF CURRENT MEASUREMENTS**

VERFAHREN ZUM LOKALISIEREN EINES ERDSCHLUSSES MIT HOHEM WIDERSTAND IN EINEM ENERGIEVERTEILERNETZ MITTELS STROMMESSUNG

PROCEDE DE LOCALISATION D'UN DEFAUT A LA TERRE HAUTE RESISTANCE DANS UN RESEAU DE DISTRIBUTION D'ENERGIE SUR LA BASE DE MESURES DE COURANT

(84) Designated Contracting States:
**DE FR GB**

(30) Priority: **27.08.1997 FI 973533**

(43) Date of publication of application:
**12.07.2000 Bulletin 2000/28**

(73) Proprietor: **ABB Oy**
**00380 Helsinki (FI)**

(72) Inventor: **LEHTONEN, Matti**
**FIN-02200 Espoo (FI)**

(74) Representative: **Lipsanen, Jari Seppo Einari et al**
**Seppo Laine Oy**
**Itämerenkatu 3 B**
**00180 Helsinki (FI)**

(56) References cited:
**EP-A1- 0 082 103**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 018 027 B1

**Description**

The invention concerns a method according to the preamble of claim 1 for the detection and location of a high-resistance earth fault in an electric distribution system. In such a method, zero sequence voltage and its phase angle as well as the zero sequence currents of the supplied line sections and their phases are measured at the distributing station, such as an electric station or a circuit breaker station, and the faulty line section is detected on the basis of the measurements.

The field of application of the method comprises faults having such a high fault resistance that it is not possible to detect the faulty feeder or line section by means of conventional relay protection. In practice this means faults of a fault resistance greater than 5 kΩ.

Conventionally, the problem of detecting an earth fault has been solved by monitoring the absolute value of the zero sequence voltage (star point to ground voltage) of the electric power system. When this value has exceeded a threshold value, an alarm has been given. This generally known prior art has been hampered by the lack of reliable, universally applicable detection means of sufficient sensitivity, when the fault resistance is greater than 20 kΩ. Some methods are known designed to solve this problem, based on, for example, measuring phase voltages and earth currents, said methods seeking to detect low-resistance earth faults.

EP 0 082 103 A describes a method for measuring the earth currents of feeders and comparing these or their variations to one another. In the method, after the measurement the highest earth current or variation of an earth current is selected and compared to a predetermined reference value. This method is approximate only and incapable of taking into account current variations caused by impedances of the normal state of the line during the fault. The accuracy and reliability of the method are, therefore, questionable.

In V. Leitloff, R. Feuillet & D. Griffel: "Detection of Resistive Single-Phase Earth Faults in a Compensated Power-Distribution System", European Transactions on Electrical Power, ETEP Vol. 7, No. 1, Jan/Feb. 1997, p. 65... 73., the so called DDA method is described. The DDA method comprises the features according to the preamble of claim 1 of the present document. Further in the DDA method, variations of the residual currents and phase voltages of feeders and of the zero sequence voltage are measured and predetermined phase-to-ground admittances are used. This information is then used to determine the fault resistances. A line having a fault resistance below a predetermined threshold value is defined as faulty. The DDA method is highly complicated.

The present invention aims at removing the drawbacks of the above-described prior art and at providing an entirely novel type of method for detecting and locating a high-resistance earth fault in a power supply system.

The invention is based on calculating measured variations in the zero sequence voltage $U_0$ and the zero sequence current $I_{0f}$ of the line or line section compared to a more long-term average, and the influence of current through the zero sequence impedance $Z_{0f}$ of the healthy state of the line is deducted from the such determined variations in the zero sequence current. On the basis of compensated current variations, a section is selected as the faulty line section where the absolute value of this current variation is at its highest and also greater than the predetermined threshold.

In more detail the method of the invention is characterized by what is stated in the characterizing part of claim 1.

The invention offers considerable benefits. By means of the method according to the invention, it is possible to locate a high-resistance single-phase earth fault in a power distribution system on the basis of current measurements more accurately and practically than at present. The method can be applied to feeder-specific current measurements at an electric station whereby the fault can be located to the feeder. Deeper in the network the method can be used e.g. in connection with circuit breaker stations whereby the fault can be located to the corresponding line section.

The invention is explained in the following by means of a number of examples.

The key idea behind the method is to measure the change $\Delta U_{0meas}$ in the zero sequence voltage during the earth fault and the corresponding change $\Delta I_{0fmeas}$ in the zero sequence current of the feeder. Next, the measured change in the zero sequence current is compensated by means of the zero sequence impedance $Z_{0f}$ of the normal state of the concerned line in vector form as follows:

$$\Delta I_{0f}' = \Delta I_{0fmeas} - \Delta U_{0meas}/Z_{0f} \qquad (1)$$

Equation 1 can be used to eliminate the influence of the direct capacitances to ground and the leak resistances of the normal state of the line from the measured zero sequence current. In a theoretical case, where the zero sequence impedance is exactly known and the measurement is faultless, the compensated current variation of a healthy line is $\Delta I_{0f}' = 0$. Theoretically, the current variation of a faulty line is $\Delta I_{0f}' = I_{EF}/3$, where $I_{EF}$ is the total earth fault current at the faulty spot.

When applying the method the equation is implemented by finding the feeder having the greatest absolute value of the variation of the compensated zero sequence current obtained by equation 1. This feeder is defined faulty if the current variation question also exceeds a predetermined threshold.

The reliability of the method can be increased by complementing it with general detection of earth faults based on some other techniques. At its simplest, this backup technique is obtained by monitoring the absolute value of the zero sequence voltage. Hereby a fault is found to have arisen if the absolute value of the zero sequence voltage exceeds a predetermined threshold. A second, more advanced alternative is to use the method described in WO 98/20356, which is prior art under Article 54(3) EPC. The method is based on detecting the earth fault by comparing the zero sequence voltage (star point to ground voltage) measured at an electric station of the system to a positive sequence component of the phase voltage measured in the network and to the total zero sequence impedance of the network. The comparison is performed with phase angles, i.e. in vector form, and it provides an estimate of the magnitude of the fault resistance. In this method, a phase is selected as faulty whose fault impedance $\underline{Z}_{EF}$ has a real part of sufficient magnitude. The document also suggests monitoring a deviation of the zero sequence voltage from its mean value over last 10 minutes.

For the use of the method of the invention it is important to know the three right-hand terms of equation (1) as well as possible. The measurement of variations ($\Delta I_{0fmeas}$ and $\Delta U_{0meas}$) of the zero sequence current $I_{0f}$ and the zero sequence voltage $U_0$ must be performed as follows:

- $U_0$ and $I_{0f}$ are measured simultaneously. The zero sequence current is measured e.g. as the sum of the phase currents or by means of a cable current transformer and the zero sequence voltage as the sum of the phase voltages.

- $\Delta U_{0meas}$ and $\Delta I_{0fmeas}$ are calculated in vector form as the difference of the measured zero sequence voltages $U_0$ and zero sequence currents $I_{0f}$ as compared to a more long-term average of the quantities in question. The time interval used in calculating the average may be e.g. 10 minutes.

- When calculating the average values and deviations from said average values ($\Delta U_{0meas}$ and $\Delta I_{0fmeas}$) of the measured zero sequence voltages $U_0$ and zero sequence currents $I_{0f}$ the phase angles of the voltages and currents are normalized using either the positive sequence voltage or the line voltage as reference.

The zero sequence impedance $Z_{0f}$ of the normal state of the line must also be known as accurately as possible. When the switching situation of the network changes the value of the zero sequence impedance $Z_{0f}$ must be updated to correspond to the new situation. The zero sequence impedance $Z_{0f}$ consists of the capacitances to earth and the leakage resistances of the lines. In an overhead line system the resistances normally stand for about 5 to 8 per cent of the conductivity in normal state. Experience shows that the value of the zero sequence impedance $Z_{0f}$ may deviate by 10 to 20 per cent from its theoretical value. In addition it is probable that its magnitude varies e.g. with the season of the year.

In order to obtain as accurate a result as possible the value of the zero sequence impedance $Z_{0f}$ of the line must be verified with measurements. For this purpose, low-resistance (< 5 kΩ) earth faults naturally occurring in the network can be exploited, whereby a great zero sequence voltage $U_0$ is generated and the faulty feeder can be detected by means of conventional protective relays. By storing during these faults variations in the zero sequence voltage $U_0$ and zero sequence current $I_{0f}$ of healthy feeders, a reliable estimate of the zero sequence impedance $Z_{0f}$ of the concerned line is obtained in vector form as follows:

$$Z_{0f} = \Delta U_{0fmeas} / \Delta I_{0fmeas} \qquad (2)$$

The storing of the basic data required by equation (2) can be carried out with the same measuring equipment as the measurement required by the basic method (equation 1). The choice between the different case alternatives (high- or low-resistance fault) in the equipment can be made by the aid of the absolute value of the measured zero sequence voltage $U_0$. For example, when the zero sequence voltage $U_0$ exceeds 50 per cent of the phase voltage in normal state, a low-resistance fault is at hand, and measurements performed during said fault are used to calculate the zero sequence impedance $Z_{0f}$ of the line unless the line in question has contact breaker functions controlled by protective relays.

In field tests the method described herein works reliably both in a network whose star point is not connected to earth and one which is earthed with an earth fault compensation coil up to a fault resistance of at least about 160 kΩ. Furthermore, in a compensated network the functionality of the method is not dependent on the degree of tuning of the coil.

**Claims**

1. A method for detecting and locating a high-resistance earth fault in an electric distribution system on the basis of current and voltage measurements at a station distributing electricity to line sections, which method comprises measuring simultaneously

    - the zero sequence voltage ($U_{0meas}$) and its phase angle and
    - the zero sequence currents ($I_{0fmeas}$) of the line sections being supplied and the phase angles thereof,

    **characterized by**

    - establishing long-term averages of the measured values of the zero sequence voltage ($U_{0meas}$) and the zero sequence currents ($I_{0fmeas}$),
    - obtaining a value of the zero sequence impedance ($Z_{0f}$) that has been verified with measurements,
    - when the switching situation of the line sections changes, updating the value of the zero sequence impedance ($Z_{0f}$) to correspond to the new situation,
    - calculating variations ($\Delta U_{0meas}$, $\Delta I_{0fmeas}$) of the zero sequence voltage ($U_{0meas}$) and the zero sequence currents ($I_{0fmeas}$) as differences compared to the long-term averages of the quantities ($U_{0meas}$, $I_{0fmeas}$) in question, wherein the variations are calculated in vector form with their phase angles and using the positive sequence voltage or the line voltage as reference for the phase angle,
    - compensating the variations ($\Delta I_{0fmeas}$) of the zero sequence currents ($I_{0fmeas}$) for the influences of the currents through the zero sequence impedances ($Z_{0f}$) of the normal state of the line sections, wherein the compensation is done in vector form, and calculating the compensated variations ($\Delta I_{0f}'$) of the zero sequence currents,
    - comparing the compensated variations ($\Delta I_{0f}'$) of the zero sequence currents to each other and selecting the greatest among these, and
    - comparing the greatest compensated variation ($\Delta I_{0f}'$) of the zero sequence currents to a predetermined threshold and, if the compared value ($\Delta I_{0f}'$) is greater than the threshold, identifying the line section in question as a faulty one.

2. The method of claim 1, **characterized by** constantly updating the value of the zero sequence impedance ($Z_{0f}$) on the basis of variations of the zero sequence voltage ($U_{0meas}$) measured during low-resistance faults naturally occurring in a power supply network and corresponding variations of the zero sequence current ($I_{0fmeas}$) of healthy line sections.

3. The method of claim 1, **characterized in that**, in the step of calculating the variations of the zero sequence voltage ($U_{0meas}$) and the zero sequence currents ($I_{0fmeas}$), the variations are calculated as differences compared to the long-term averages of the measured values immediately preceding the last measurements,

4. The method of claim 1, **characterized in that**, in the step of calculating the variations of the zero sequence voltage ($U_{0meas}$) and the zero sequence currents ($I_{0fmeas}$), the variations are calculated as differences compared to the long-term averages of the measured values of the last 10 minutes before the last measurement.


**Patentansprüche**

1. Verfahren zum Detektieren und Lokalisieren eines Erdschlusses von hohem Widerstand in einem Elektrizitätsverteilersystem basierend auf Strom- und Spannungsmessungen an einer Station, von der Elektrizität an Leitungsabschnitte verteilt wird, wobei das Verfahren simultan
    die Nullsystemspannung ($U_{0meas}$) und ihren Phasenwinkel und
    die Nullsystemströme ($I_{0fmeas}$) der versorgten Leitungsabschnitte und die Phasenwinkel davon misst,
    **gekennzeichnet durch**
    Ermitteln von Langzeitmittelwerten der gemessenen Werte der Nullsystemspannung ($U_{0meas}$) und der Nullsystemströme ($I_{0fmeas}$)
    Gewinnen eines Wertes für die Nullsystemimpedanz (Zof), die **durch** die Messungen verifiziert wurde,
    wenn der Schaltzustand der Leitungsabschnitte sich ändert, Aktualisieren des Wertes der Nullsystemimpedanz ($Z_{0f}$), um der neuen Situation zu entsprechen,
    Berechnen von Variationen ($\Delta U_{0meas}$, $\Delta I_{0fmeas}$) der Nullsystemspannung ($U_{0meas}$) und der Nullsystemströme ($I_{0fmeas}$) als Unterschiede verglichen zu den Langzeitmittelwerten der gefragten Größen ($U_{0meas}$, $I_{0fmeas}$), wobei die Variationen in Vektorform mit deren Phasenwinkeln und unter Verwendung der Mitsystemspannung oder der Leitungsspannung als Referenz für den Phasenwinkel berechnet werden,

Kompensieren der Variationen ($\Delta I_{0fmeas}$) der Nullsystemströme ($I_{0fmeas}$) für die Einflüsse der Ströme **durch** die Nullsystemimpedanzen ($Z_{0f}$) des Normalzustands der Leituhgsabschnitte, wobei die Kompensierung in Vektorform gemacht wird, und Berechnen des kompensierten Variationen ($\Delta I_{0f}'$) der Nullsystemströme,

Vergleichen der kompensierten Variationen ($\Delta I_{0f}'$) der Nullsystemströme miteinander und Auswählen des größten davon, und

Vergleichen der größten kompensierten Variation ($\Delta I_{0f}'$) der Nullsystemströme mit einem vorbestimmten Schwellenwert und, falls der Vergleichswert ($\Delta I_{0f}'$) größer als der Schwellenwert ist, Identifizieren des in Frage kommenden Leitungsabschnitts als ein fehlerhafter Leitungsabschnitt.

**2.** Verfahren gemäß Anspruch 1, **gekennzeichnet durch** ständiges Aktualisieren des Wertes der Nullsystemimpedanz ($Z_{0f}$) basierend auf Variationen der Nullsystemspannung ($U_{0meas}$), gemessen während störungen von geringem Widerstand, die naturgemäß in Stromversorgungsnetzwerken auftreten, und auf korrespondierenden Variationen des Nullsystemstroms ($\Delta I_{0fmeas}$) der intakten Leitungsabschnitte.

**3.** Verfahren gemäß Anspruch 1, **gekennzeichnet dadurch, dass** in dem Schritt des Berechnens der Variationen der Nullsystemspannung ($U_{0meas}$) und der Nullsystemströme ($I_{0fmeas}$) die Variationen als Unterschiede verglichen zu den Langzeitmittelwerten der gemessenen Werte, die der letzten Messung unmittelbar vorangehen, berechnet werden.

**4.** Verfahren gemäß Anspruch 1, **gekennzeichnet dadurch, dass** in dem Schritt des Berechnens der Variationen der Nullsystemspannung ($U_{0meas}$) und der Nullsystemströme ($I_{0fmeas}$) die Variationen als Unterschiede verglichen zu den Langzeitmittelwerten der gemessenen Werte der letzten 10 Minuten vor der letzten Messung berechnet werden.

**Revendications**

**1.** Procédé de détection et de localisation d'un défaut à la terre à haute résistance dans un réseau de distribution d'énergie électrique sur la base de mesures du courant et de la tension au niveau d'une station distribuant de l'électricité à des sections de lignes, lendit procédé comprenant la mesure simultanée

- de la tension homopolaire ($U_{0meas}$) et de son angle de phase, et
- des courants homopolaires ($I_{0fmeas}$) des sections de lignes alimentées et des angles de phase de ceux-ci,

**caractérisé par**

- l'établissement de moyennes à long terme des valeurs mesurées de la tension homopolaire ($U_{0meas}$) et des courants homopolaires ($I_{0fmeas}$),
- l'obtention d'une valeur de l'impédance homopolaire ($Z_{0f}$) qui a été vérifiée avec les mesures,
- lorsque la situation de commutation des sections de lignes change, la mise à jour de la valeur de l'impédance homopolaire ($Z_{0f}$) afin de correspondre à la nouvelle situation,
- le calcul des variations ($\Delta U_{0meas}$, $\Delta I_{0fmeas}$) de la tension homopolaire ($U_{0meas}$) et des courants homopolaires ($I_{0fmeas}$) comme des différences comparées avec les moyennes à long terme des quantité ($U_{0meas}$, $I_{0fmeas}$) en question, où les variations sont calculées sous forme vectorielle avec leurs angles de phase et en utilisant la tension positive ou la tension de ligne comme référence pour l'angle de phase,
- la compensation des variations ($\Delta I_{0fmeas}$) des courants homopolaires ($I_{0fmeas}$) pour les influences des courants par rapport aux impédances homopolaires ($Z_{0f}$) de l'état normal des sections de lignes, où la compensation est effectuée sous forme vectorielle, et le calcul des variations compensées ($\Delta I_{0f}$) des courants homopolaires,
- la comparaison des variations compensées ($\Delta I_{0f}$) des courants homopolaires les unes avec les autres et la sélection de la plus élevée d'entre elles, et
- la comparaison de la variation compensée la plus élevée ($\Delta I_{0f}$) des courants homopolaires avec un seuil prédéterminé, et, si la valeur comparée ($\Delta I_{0f}'$) est supérieure au seuil, l'identification de la section de ligne en question comme étant défaillante.

**2.** Procédé selon la revendication 1, **caractérisé par** la mise à jour constante de la valeur de l'impédance homopolaire ($Z_{0f}$) sur la base des variations de la tension homopolaire ($U_{0meas}$) mesurées pendant les défaut à faible résistance ayant naturellement lieu sur un réseau d'alimentation en électricité et des variations correspondantes du courant homopolaire ($I_{0fmeas}$) de sections de lignes saines.

3. Procédé selon la revendication 1, **caractérisé en ce que**, à l'étape de calcul des variations de la tension homopolaire ($U_{0meas}$) et des courants homopolaires ($I_{0meas}$), les variations sont calculées comme des différences comparées avec les moyennes à long terme des valeurs mesurées juste avant la dernière mesure.

4. Procédé selon la revendication 1, **caractérisé en ce que**, à l'étape de calcul des variations de la tension homopolaire ($U_{0meas}$) et des courants homopolaires ($I_{0fmeas}$), les variations sont calculées comme des différences comparées avec les moyennes à long terme des valeurs mesurées des 10 dernières minutes précédant la dernière mesure.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0082103 A

- WO 9820356 A

**Non-patent literature cited in the description**

- **V. LEITLOFF ; R. FEUILLET ; D. GRIFFEL.** Detection of Resistive Single-Phase Earth Faults in a Compensated Power-Distribution System. *European Transactions on Electrical Power, ETEP,* January 1997, vol. 7 (1), 65...73